# EUROPÄISCHE PATENTSCHRIFT

(11) **EP 2 726 438 B1**
(45) Veröffentlichungstag und Bekanntmachung des Hinweises auf die Patenterteilung: **30.05.2018**
(21) Anmeldenummer: 12729997.2
(22) Anmeldetag: 29.06.2012
(51) Int. Cl.: C04B 35/462, C04B 35/475, C01G 29/00, H01L 41/43, H01L 41/187

(54) **VERFAHREN ZUR HERSTELLUNG EINES PIEZOKERAMISCHEN BLEIFREIEN WERKSTOFFS**
METHOD OF MAKING A PIEZOCERAMIC LEAD-FREE MATERIAL
PROCÉDÉ DE PRÉPARATION D'UN MATÉRIAU PIÉZOCÉRAMIQUE SANS PLOMB

(30) Priorität: 01.07.2011 DE 102011078536
(43) Veröffentlichungstag der Anmeldung: 07.05.2014
(73) Patentinhaber: CeramTec GmbH, 73207 Plochingen (DE)
(72) Erfinder: APEL, Friederike, 90607 Rückersdorf (DE); SCHREINER, Hans-Jürgen, 91217 Hersbruck (DE); VOIGT, Claudia, 09603 Großschirma (DE)
(74) Vertreter: Fehrenbacher, Eckhard Anton
(86) Internationale Anmeldenummer: PCT/EP2012/062721
(87) Internationale Veröffentlichungsnummer: WO 2013/004622

(56) Entgegenhaltungen:
- EP-A2- 2 113 495
- CN-A- 101 913 868
- WEN CHEN ET AL: "Electromechanical Properties and Morphotropic Phase Boundary of Na0.5Bi0.5TiO3-K0.5Bi0.5TiO3-BaTiO3 Lead-free Piezoelectric Ceramics", JOURNAL OF ELECTROCERAMICS, KLUWER ACADEMIC PUBLISHERS, BO, Bd. 15, Nr. 3, 1. Dezember 2005 (2005-12-01), Seiten 229-235, XP019208319, ISSN: 1573-8663, DOI: 10.1007/S10832-005-3301-0
- YU HUICHUN ET AL: "Dielectric, ferroelectric, and piezoelectric properties of the lead-free (1â x)(Na0.5Bi0.5)TiO3-xBiAlO3 solid solution", APPLIED PHYSICS LETTERS, AIP, AMERICAN INSTITUTE OF PHYSICS, MELVILLE, NY, US, Bd. 93, Nr. 11, 15. September 2008 (2008-09-15), Seiten 112902-112902, XP012111493, ISSN: 0003-6951, DOI: 10.1063/1.2967335

## Beschreibung

Gegenstand der vorliegenden Erfindung ist ein Verfahren zur Herstellung eines piezoelektrischen bleifreien Werkstoffs auf Basis von Bismut-Natrium-Titanat.

Piezoelektrische Keramiken (Piezokeramiken) haben ein breites Anwendungsfeld im Bereich der Sensorik (Messen von Kräften, Beschleunigungen und Drücken) und der Aktorik (Positioniertechnik und Ultraschallgenerierung).

Für den Einsatz von Piezokeramik, insbesondere in der KFZ-Technik (Klopfsensoren, Drehraten-Sensoren, Rückfahrsensoren), sind Werkstoffe mit hoher piezoelektrischer Aktivität bei thermischer und zeitlicher Stabilität (hohe Curie-Temperatur, geringen Temperaturkoeffizienten und niedrigen Alterungsraten) der funktionellen Kenngrößen erforderlich.

Piezokeramische Werkstoffe bestehen seit langem aus Zusammensetzungen auf der Basis der festen Lösungen (Mischkristalle) von Bleizirkonat (PbZrO₃) und Bleititanat (PbTiO₃). Vielfältige Modifikationen des Grundsystems sind durch Substitution und/oder Zusatz von Metallionen in begrenzten Konzentrationen möglich, wenn die betreffenden Ionen Voraussetzungen bezüglich Wertigkeit, lonenradius und Charakter der chemischen Bindung erfüllen.

Eine Modifikation der Grundzusammensetzung durch Dotierung mit Ionen abweichender Wertigkeit gegenüber den ursprünglichen Ionen führt zu einer Diversifizierung der dielektrischen und elektromechanischen Eigenschaften.

Als Ersatz für Bleizirkonattitanat-Keramiken können unter bestimmten Voraussetzungen Verbindungen mit Perowskitstruktur wie BiFeO₃, KNbO₃, NaNbO₃, Na_{0,5}Bi_{0,5}TiO₃ dienen.

Diese Piezokeramiken gehören den Ferroelektrika. Als keramische Ferroelektrika sind auch bleifreie Zusammensetzungen, wie (K,Na)NbO₃, (Sr₁₋ₓBaₓ)Nb₂O₅ bekannt, die jedoch nicht die Eigenschaften von bekannten PZT-basierten Systemen erreichen.

Insgesamt existiert mit den unterschiedlichsten Modifikationen der Grundsysteme bereits eine große Zusammensetzungsvielfalt, mit der es in vielen Fällen möglich war, eine jeweils anwendungsgerechte Spezifikation der dielektrischen und elektromechanischen Eigenschaften piezoelektrischer Werkstoffe für unterschiedliche Wandlerfunktionen zu realisieren.

Nachteilig bei den bekannten Bleizirkonattitanat-Keramiken ist das als Hauptkomponente verwendete Bleioxid, genauer Pb²⁺, das im Perowskitgitter fest gebunden ist. Aufgrund der schlechten Umweltverträglichkeit von Bleioxid sollen daher zukünftig vorzugsweise bleifreie Piezokeramiken zum Einsatz kommen. Ein System, das sich im Bereich der bleifreien Systeme als vielversprechend herausgestellt hat, ist das Bi_{0,5}Na_{0,5}TiO₃-System (Bismut-Natrium-Titanat (BNT)). Doch auch dieses System hat einige Nachteile:
Auf Grund der Löslichkeit von Natriumcarbonat in Wasser und den daraus resultierenden Homogenitätsproblemen wird bei der Herstellung von Bismut-Natrium-Titanat, Ethanol als Lösungsmittel genutzt. Dies hat zur Folge, dass Auflagen zur Arbeit mit explosiven Stoffen sowie Umweltauflagen eingehalten werden müssen, was aufwendigere Verfahren und teurere Anlagen zur Folge hat. Ein Teil der Vorteile, die durch die Verwendung von bleifreien Systemen erreicht wird, wird durch diese zusätzlichen Auflagen wieder aufgehoben.

Weiterhin besteht bei der Sinterung von Bismut-Natrium-Titanat das Problem, dass Sauerstoffleerstellen entstehen, wodurch die Leitfähigkeit des Materials steigt und die Polarisation erschwert wird. CN101913868 zeigt die Verwendung von K₂CO₃, Na₂CO₃ und Nb₂O₅ zur Herstellung von K_{0.5}Na_{0.5}NbO₃. Aufgabe der vorliegenden Erfindung war daher, einen bleifreien piezokeramischen Werkstoff im System Bismut-Natrium-Titanat mit minimalen Sauerstoffleerstellen bereitzustellen, dessen Herstellung im wässrigen System erfolgen kann.

Die Kontrolle über die Bildung der Sauerstoffleerstellen im Prozess stellt somit ein wesentliches Merkmal des erfindungsgemäßen Verfahrens dar.

Gelöst wurde die der Erfindung zugrundeliegende Aufgabe durch die Merkmale des Hauptanspruchs. Vorzugsweise Ausgestaltungen sind in den Unteransprüchen definiert.

Demgemäß sieht ein erfindungsgemäßes Verfahren zur Herstellung eines piezokeramischen bleifreien Werkstoffs aus Bismut-Natrium-Titanat vor, dass als Natrium- und Bismutquelle Natriumbismutat (NaBiO₃) eingesetzt wird.

Im System Bi_{0,5}³⁺Na_{0,5}¹⁺Ti⁴⁺O₃²⁻ (BNT) liegt eine stöchiometrische Verbindung vor. Sauerstoffleerstellen können durch Fremdstoffe, d.h. Verunreinigungen oder auch durch die Prozesse des Kalzinierens und Sinterns erzeugt werden. Dem wird durch die Verwendung von Na¹⁺Bi⁵⁺O₃²⁻ vorgebeugt. In dieser Verbindung ist die Sauerstoffkonzentration im Vergleich zum BNT höher und beim Sintern wird durch Reduktion des Bi⁵⁺ zu Bi³⁺ Sauerstoff freigesetzt.

Damit erfolgt die Sinterung vorteilhaft in einer sauerstoffreichen Umgebung, was die Entstehung von Sauerstoffleerstellen verhindert/minimiert oder jedenfalls wesentlich vermindert.

Hinzu kommt, dass die Sintertemperatur um bis zu 50°C gesenkt werden kann. Dadurch ist größerer Abstand zur Schmelztemperatur, die beispielsweise bei etwa 1250°C liegen kann, gegeben. Durch die Senkung der Prozesstemperatur wird das Verfahren daher auch energieeffizienter.

Gemäß einer bevorzugten Weiterbildung der Erfindung wird der piezokeramische Werkstoff in einem wässrigen System gemischt und gemahlen. Dies hat den Vorteil, dass Auflagen zur Arbeit mit explosiven Stoffen keine Anwendung finden, da Ethanol als Lösungsmittel wegfällt.

Umweltauflagen aufgrund des Bleigehalts von PZT-Keramiken finden ebenfalls keine Anwendung, weil der Bleigehalt minimiert ist; besonders bevorzugt beträgt der Anteil an Blei unter 0,1 mas%.

Ein piezokeramischer bleifreier Werkstoff kann beispielsweise im Bereich der Sensorik, insbesondere zum Messen von Kräften, Beschleunigungen und Drücken sowie der Aktorik, insbesondere der Positioniertechnik und Ultraschallgenerierung verwendet werden.

## Patentansprüche

1. Verfahren zur Herstellung eines piezokeramischen bleifreien Werkstoffs Bismut-Natrium-Titanat, **dadurch gekennzeichnet, dass** als Natrium- und Bismutquelle Natriumbismutat (NaBiO₃) eingesetzt wird.

2. Verfahren gemäß Anspruch 1, **dadurch gekennzeichnet, dass** der piezokeramische Werkstoff in einem wässrigen System gemischt und gemahlen wird.

## Claims

1. A method for producing a piezoceramic lead-free bismuth-sodium-titanate material, **characterised in that** sodium bismuthate (NaBiO₃) is used as the sodium and bismuth source.

2. A method according to claim 1, **characterised in that** the piezoceramic material is mixed and ground in an aqueous system.

## Revendications

1. Procédé de préparation d'un matériau piézocéramique sans plomb, en titanate de bismuth et de sodium, **caractérisé en ce que** l'on utilise, en tant que source de sodium et de bismuth, du bismuthate de sodium NaBiO₃.

2. Procédé conforme à la revendication 1, **caractérisé en ce que** le matériau piézocéramique est mélangé dans un système aqueux et y est moulu.
